# EUROPEAN PATENT SPECIFICATION

(11) **EP 1 236 760 B1**
(45) Date of publication and mention of the grant of the patent: **26.10.2005**
(21) Application number: 02251191.9
(22) Date of filing: 21.02.2002
(51) Int. Cl.: C08J 7/02, C09K 13/00, C23C 18/26

(54) **Solvent swell for texturing resinous material and desmearing and removing resinous material**
Quelllösung zur Texturierung und Säuberung von Polymeroberflächen
Solvant gonflant pour la texturation et le décapage et l'ébeurrage de surfaces polymériques

(30) Priority: 23.02.2001 GB 0104503
(43) Date of publication of application: 04.09.2002
(73) Proprietor: Shipley Company LLC, Marlborough, MA 01752 (US)
(72) Inventor: Hirst, Deborah V., Nuneaton, Warwickshire CV11 4FS (GB); Poole, Mark A., Rugby, Warwickshire CV22 7EA (GB); Green, Susan, Stratford on Avon, Warwickshire CV37 7LP (GB); Sinitskaya, Inna, Sudbury, Massachusetts 01776 (US); Graves, John E., Nuneaton, Warwickshire, CV11 6YT (GB)
(74) Representative: Kent, Venetia Katherine

(56) References cited:
- EP-A- 0 421 123
- DE-A- 19 539 394
- US-A- 3 963 590
- US-A- 5 019 425
- US-A- 5 308 527
- US-A- 5 985 040
- PATENT ABSTRACTS OF JAPAN vol. 1995, no. 09, 31 October 1995 (1995-10-31) & JP 07 166195 A (TONEN CORP), 27 June 1995 (1995-06-27)

## Description

### Background of the Invention

The present invention is directed to a solvent swell composition and method for texturing resinous material as well as desmearing and removing resinous material from a substrate. More specifically, the present invention is directed to a lactone containing solvent swell composition and method for texturing resinous material as well as desmearing and removing resinous material from a substrate.

Coating or plating a nonconductive substrate with a continuous metal coating or patterned or discontinuous metal coating or plating has been employed in a number of industries and applications for many years. Such substrates arc often composite substrates composed of a resin sheet having a thin metal foil laminated or clad to both sides of the plastic sheet leaving the nonconductive plastic sandwiched between the two metal surfaces. Holes are often drilled through the metal clad and the resin exposing the resin where the holes are drilled. The composite substrates, after being metal plated, may be used to produce printed circuit boards for electrical or electronic applications.

Hole forming operations in resin containing materials often result in the smearing of resin over the interior wall or barrel of the hole. This resin smear is primarily attributable to the generation or utilization of temperatures exceeding those at which resinous components decompose during the hole forming process.

Where holes are drilled in epoxy impregnated fiberglass laminate materials, such as those employed to make printed circuit boards, friction of the drill bit against the material raises the temperature of the bit. Often drill bit temperatures are generated which exceed the decomposition temperature of many resin systems. The drill bit thus picks up resinous components on its course through the material being drilled, and this resinous accretion is smeared in the barrel of the hole. In laser drilling operations, to contact interior conductors in organic insulating substrates, a similar resinous accretion or smear can develop on the exposed conductor surface.

While the problem of resin smear on the hole walls may be ignored in some applications, it is at times imperative that it be removed such as in the manufacture of printed circuit boards. Printed circuit boards are used for a variety of electrical applications and provide the advantage of conservation of weight and space. A printed circuit board comprises one or more circuit layers, each circuit layer separated from another by one or more layers of dielectric material. Circuit layers are formed by patterning a copper layer on the polymeric substrate. Printed circuits are then formed on the copper layers by techniques well known to the art, for example print and etch to define and produce the circuit traces, that is, discrete circuit lines in a desired circuit pattern. Once the circuit patterns are formed, a stack is formed comprising multiple circuit layers separated from each other by a dielectric layer, typically a resin-containing material such as epoxy, epoxy/glass or polyimide. Once the stack is formed, it is subjected to heat and pressure to form the laminated multilayer circuit board. When such a multilayer circuit board is made, holes are formed in the resin-containing material that includes a plurality of parallel planar metallic conductors, with the hole perpendicular to, and communicating with, two or more parallel metallic conductors. It is often desired to metallize the hole walls in order to form a conductive path between two or more of the metallic conductors. In such instances, the resin smear must be removed from the hole walls through the metallic conductors if conductive contact between the metallized hole wall and the metallic conductors is to be achieved. Thus, when circuit board holes are drilled through a copper clad base polymeric substrate or through a laminate containing internal conductor planes such as in a multilayer circuit board, resin smear on the metallic surfaces exposed to the walls of the holes must be removed to achieve proper functioning of the metallized, or plated, through-holes.

Plated through-holes, as described above, are useful as electrical connections between printed circuits having metallic conductors on both sides of the resinous or plastic laminate or between two or more of the various planes and surface conductor layers in multilayer boards. The electrical and mechanical integrity required for this function can only be attained by insuring complete removal of resinous materials from the entire inner circumference of the portion of the metallic conductor exposed by the hole.

Numerous methods are known for removing resin smear. For example, plasma is widely used which removes resinous components by vapourisation. Another approach is a mechanical one and involves channeling a dry or wet stream of abrasive particles through such holes. A similar method uses hydraulic pressure to force a thick slurry of abrasive material through the holes, However, these mechanical methods arc slow and difficult to control and complete removal of smear in all holes in a given circuit board is difficult to achieve.

Chemical methods are used to desmear holes formed during printed circuit board manufacture. The most common chemical method is treatment with a permanganate solution, such as potassium or sodium permanganate. In general, such permanganate solutions are alkaline.

Permanganate treatment is also used to texturize or micro-roughen the surface of resinous material, such as dielectrics used in printed wiring board manufacture. While not intending to be bound by theory, such textured surfaces are thought to improve metal, particularly copper, adhesion to the resinous material. Resinous materials show a relatively poor affinity for metal and to promote a stronger bond between a resinous substrate and a metallic coating the art has frequently resorted to micro-roughening or texturing the resinous surface to provide locking or keying between the surface and a metal coating. Thus, texturing resinous material with permanganate treatment is important in obtaining a metal coating on the resinous material.

Permanganate treatment involves three different treatment solutions used sequentially. They arc (1) a solvent swell solution, (2) a permanganate desmcar solution, and (3) a neutralization solution. A printed wiring board is dipped or otherwise exposed to each solution with water rinse baths employed between each of these three treatment solutions.

The solvent swell solution or composition typically contains an organic solvent or a mixture of solvents which renders the resinous material more amenable to removal by the permanganate. Such solvent swell compositions are generally alkaline. For example, European Patent Application EP 454 929 (Retallick et al.) discloses a method for improving the adhesion of metal to a polyimide substrate by first contacting the substrate with a composition of water, butyl carbitol, ethylene glycol and sodium hydroxide, i.e. solvent swell, followed by contact with an aqueous alkaline permanganate solution.

U.S. Patent No. 5,985,040 (Carano et al.) discloses a permanganate texturizing step in the manufacture of printed wiring boards using a solvent swell composition of from about 10% to about 30% by volume of gamma butyrolactone and from about 70% to about 90% by volume of N-methyl-2-pyrrolidone.

U.S. Patent No. 5,015,339 (Pendleton) discloses a permanganate texturizing step in the manufacture of printed wiring boards. In this patent, a solvent swell step using a composition containing an alkali metal hydroxide and glycol ether or other solvent, such as N-methylpyrrolidone ("NMP"), is disclosed.

U.S. Patent No. 4,086,128 (Sugio et al.) discloses a variety of solvents for swelling resinous materials prior to a hydrogen peroxide and sulfuric acid etch step. Combinations of acids and solvents are not disclosed.

US-A-3,963,590 discloses a process for electroplating a shaped article of polyoxymethylene by treatment with quinoline or gamma-butyrolactione prior to treatment with an etching agent.

EP-A-0 421 123 discloses a process for promoting adhesion of metal to thermoplastic substrates such as polyimides.

US-A-5,985,040 discloses a desmear process for removing resin smeared on an interior wall of a through hole drilled in a resinous substrate, such as epoxy or polyimide.

US-A-5,019,425 discloses a process for pretreatment of synthetic materials particularly polyetherimide and polycarbonate.

In an effort to increase manufacturing throughput, particularly of printed wiring boards, ways have been sought to decrease the number of process steps, time of each process step or both. Reducing the time of each process step is especially important for horizontal methods of making printed circuit boards as opposed to vertical methods. Horizontal methods are more expensive than vertical methods because of the use of costly equipment. Thus solvent swell and permanganate dwell times on the resin material are shorter in horizontal methods than in vertical methods. The solvent swell and permanganate must effectively desmear and texturize the resin within a shorter time period. Also, many resin materials that are highly desirable in the manufacture of printed circuit boards have high Tg values such as from about 150° C to about 180° C or greater and are chemically resistant to many solvent swell and texturing compositions. Such high Tg resins are particularly suitable for use in sequential build up ("SBU") applications.

As mentioned above texturing improves the adhesion between a resin material and a metal coating. Poor adhesion between resins and the metal coating allows differential dimensional changes with temperature that may result in warping, blistering, and cracking of the metallized product. Consequently, strong adhesion between a resin substrate and the metal layer is essential for any application in which the product is subjected to significant temperature fluctuations. More importantly, the strong adhesion between resins and metal layers is such that de-lamination does not occur during use of the product. Thus, the life of the product is prolonged.

Accordingly, there is a need for solvent swell techniques that are effective in substantially increasing the texturing of resinous material to improve adhesion between a resinous material and a metal layer.

### Summary of the Invention

The present invention in its various aspects is as set out in the accompanying claims. The present invention is directed to a solvent swell composition containing a lactone and a method of using the composition to treat a resinous substrate such that the solvent swell conditions the resinous substrate for texturing or micro-roughening with an etchant. Advantageously, the lactone containing solvent swell compositions contain a lactone in a sufficient amount to condition a resinous substrate such that contacting the conditioned resinous substrate with an etchant provides porous texturing of the resinous substrate. The porous resinous substrate provides a mechanical means by which a deposited metal may anchor onto the resinous surface to form the high integrity bond with the resin. Such high integrity bonding prevents warping, blistering and cracking of the metallized substrate. Also, the metal resin bond does not readily de-laminate.

Additionally, the lactone containing solvent swell compositions and methods of the present invention provide effective desmearing and removal of resinous material from a substrate. The lactones may be employed in the solvent swell composition alone or mixed with an amide or another organic solvent. The present invention is particularly effective for use with resinous material that is used in the manufacture of printed wiring boards.

Advantageously, the solvent swell compositions and methods may be effectively employed in both horizontal and vertical methods of manufacturing printed circuit boards. The solvent swell compositions may be employed over short dwell times, thus providing highly suitable solvent swell compositions and methods for horizontal circuit board manufacturing methods. Also, the solvent swell compositions and methods may be effectively used to texture and desmear both high and low Tg resins.

A primary objective of the present invention is to provide a composition containing one or more lactones that conditions a resinous material to be substantially textured with an etchant.

Another objective of the present invention is to provide a composition containing one or more lactones that removes resinous material from a substrate.

A further objective of the present invention is to provide a method for substantially texturing resinous material of a substrate including the steps of first contacting the resinous material with a composition including one or more lactones; and then contacting the resinous material with an etching composition.

Yet another objective of the present invention is to provide a method for desmearing resin from the inside walls of holes formed in resinous substrates including the steps of first contacting the resinous substrate with a composition including one or more lactones; and then contacting the resinous substrate with an etching composition.

Additional advantages and objectives will become apparent to those of skill in the art after reading the following detailed description and the appended claims.

### Brief Description of the Drawings

Figs. 1A-B are electron micrographs taken at 2000X of a Isola resin material (1A) and a Polyclad® resin material (1B) textured with standard de-smear chemistry;
Figs 2A-B are electron micrographs taken at 2000X of a Isola resin material (2A) and a Polyclad® resin material (2B) textured with a 40% bv cpsilon-caprolactone/30% bv N-methyl-2-pyrrolidone solution and the balance water;
Figs. 3A-B are electron micrographs taken at 2000X of a Isola resin material (3A) and a Polyclad® resin material (3B) textured with a 40% bv gamma-butyrolactone/30% bv N-methyl-2-pyrrolidone solution and the balance water;
Figs. 4A-J are electron micrographs taken at 2000X of a Isola resin material (4A, C, E, G and I) textured with a 10%-50% bv aqueous epsilon-caprolactone solution and a Polyclad® resin material (4B, D, F, H, and J) textured with a 10%-50% bv aqueous epsilon-caprolactone solution;
Figs. 5A-J are electron micrographs taken at 2000X of Isola resin material (5A, C, E, G, and I) textured with a 10%-50% aqueous gamma-butyrolactone solution and a Polyclad® resin material (5B, D, F, H, and J) textured with a 10%-50% bv aqueous gamma butyrolactone solution;
Figs. 6A-D are electron micrographs taken at 2000X of a Isola resin material (6A and C) textured with a 10%-15% bv aqueous gamma-caprolactone solution and a Polyclad® resin material (6B and D) textured with a 10%-15% bv aqueous gamma-caprolactone solution;
Fig. 7 is a graph showing weight loss, actual and expected, of resin material that was treated with a solvent swell composition by plotting weight change/mg/cm² of resin material vs concentration of solvent component/% of Vol.
Fig. 8 is another graph showing weight loss, actual and expected, of resin material that was treated with a solvent swell composition by plotting weight change/mg/cm² vs concentration of solvent component/% of Vol.

### Detailed Description of the Invention

As used throughout this specification, the abbreviations given shall have the following meanings, unless the context clearly indicates otherwise: g = gram; mg = milligram; cm = centimeter; DI = dcionized; ° C = degrees Centigrade; M = molar; g/l = grams per liter; bv = by volume; wt% = percent by weight; and Tg = glass transition temperature.

The terms "printed circuit board" and "printed wiring board" are used interchangeably throughout this specification. The term "alkyl" or "alkane" refers to linear, branched or cyclic alkyl or alkane, Likewise, the term "alkenyl" or "alkene" refers to linear, branched or cyclic alkenyl or alkene. All amounts are percent by volume, unless otherwise noted. All numerical ranges arc inclusive and are combinable.

The solvent swell compositions of the present invention include one or more lactones. The solvent swell compositions are employed to condition or treat a resinous material such that the resinous material becomes substantially textured or micro-roughened when the conditioned or treated resinous material is etched. The lactones that may be employed include any suitable lactone in a sufficient quantity that conditions a resinous material such that upon etching the conditioned resinous material a porous texture is formed thereon. Porous, as defined within the scope of the present invention, means a state of a solid body penetrated by minute open spaces filled with a liquid or a gas. Porosity (P) may be expressed as the percentage of open space in the total volume. The lactone solvent swell method of the present invention provides a porosity of at least about 40%. Preferably the method of the present invention provides a porosity of from about 60% to about 90%. Also, the method of the present invention may employ lactones in a sufficient quantity to desmear and remove resinous material from a substrate.

Suitable lactones that may provide a porous texture on a resinous material and/or de-smear resinous material from a substrate are epsilon-caprolactone, gamma-caprolactone, gamma-valerolactone and derivatives thereof. Preferred lactones consist of epsilon-caprolactone, and gamma-caprolactone, and derivatives thereof.

The solvent swell compositions also may contain an amide in addition to the one or more lactones. Suitable amides include amides that are effective in swelling resinous material and conditioning resinous material for texturing. Such amides include, but are not limited to, N-methyl-2-pyrrolidone, 2-pyrrolidone, N-ethyl-2-pyrrolidone, N-cyclohexyl-2-pyrrolidone, N-dodecyl-2-pyrrolidone, N-(2-hydroxyethyl)-2-pyrrolidone, or dimethylacetamide. Preferred amides consist of N-methyl-2-pyrrolidone and N-(2-hydroxyethyl)-2-pyrrolidone.

Optional organic solvents that also may be included are any organic solvents which are effective in swelling resinous material, such as, but are not limited to, glycols, glycol ethers, glycol ether acetates, ketones, esters, aldehydes, alcohols, heterocyclic amines. Suitable organic solvents include, but are not limited to, ethylene glycol, diethylene glycol, triethylene glycol, polyethylene glycol, propylene glycol, dipropylene glycol, tripropylene glycol, polypropylene glycol, (C₁-C₄) glycol ethers such as diethylene glycol monomethyl ether, diethylene glycol monopropyl ether, diethylene glycol monobutyl ether, ethylene glycol monomethyl ether, ethylene glycol monopropyl ether, ethylene glycol monobutyl ether, ethylene glycol phenyl ether, dipropylene glycol monomethyl ether, dipropylene glycol monopropyl ether and dipropylene glycol monobutyl ether, (C₁-C₄) glycol ether acetates such as dipropylene glycol monomethyl ether acetate and propylene glycol monomethyl ether acetate, propylene glycol pehnyl ether, (C₁-C₁₂) alkyl acetates such as ethyl acetate, amyl acetate, butyl acetate, propyl acetate, ethyl lactate; ethyl butyrate, acetone, hexanone, pentanone, glyoxal, tetrahydrofuran. Also, alkylene carbonates such as ethylene carbonate, propylene carbonate, and the like may be employed. Such solvents are generally commercially available and may be used without further purification. Preferred solvents include the alkylene carbonates, especially ethylene carbonate and propylene carbonate. Such solvents are high flash point solvents and do not present a flammable hazard as some of the above optional solvents do during circuit board manufacture. Also, the amide N-(2-hydroxyethyl)-2-pyrrolidone has a high flash point and is a preferred amide that may be mixed with the one or more lactones.

Any amount of the above-identified lactones may be used to practice the present invention as long as the lactones condition resinous material such that etching the resinous material forms a porous texture on the resin, and/or desmears a substrate of resin. Generally, the amount of lactone in the solvent swell is from about 0.25% to about 100 % bv based on the total volume of the composition, preferably from about 20% to about 80 % bv, and more preferably from about 30% to about 60 % bv. A preferred lactone solvent swell contains epsilon-caprolactone at a concentration of at least about 20% bv, preferably at least about 30% bv, most preferably at least about 40% bv with the balance water. Another preferred lactone solvent swell contains gamma-caprolactone at a concentration of about 1.0% bv to about 20% bv, preferably from about 10% bv to about 15% bv with the balance water.

When an amide is combined with one or more lactones in the solvent swell composition, the amide generally is from about 1% to about 99% bv based on the total volume of the composition. Preferably the amide generally is from about 40% to about 80% bv of the composition. The lactone amount generally may range from about 0.25% bv to about 99% bv, preferably from about 5% bv to about 30% bv. The balance may be water, an optional organic solvent, or combinations thereof. An exemplary composition containing a lactone and an amide is epsilon-caprolactone and N-methyl-2-pyrrolidone. Each component is employed in sufficient quantity to obtain some porous texturing of a resinous material. The epsilon-caprolactone may range from at least about 10% bv. The N-methyl-2-pyrrolidone may range from at least about 10% bv. Preferably, the epsilon-caprolactone and the N-methyl-2-pyrrolidone each compose at least about 20% bv of the formulation. A preferred range is about 20% bv to about 70% bv of epsilon-caprolactonc, and about 20% to about 70% bv epsilon N-methyl-2-pyrrolidone. Most preferably the epsilon-caprolactone ranges from about 30% bv to about 50% bv, and the N-methyl-2-pyrrolidone ranges from about 30% bv to about 50% bv. Examples of exemplary epsilon-caprolactone formulations-include about 30% bv epsilon-caprolactone/about 50% bv N-methyl-2-pyrrolidone with the balance water; and about 30% bv epsilon-caprolactone/about 40% bv N-mcthyl-2-pyrrolidonc and the balance water.

Preferred gamma-caprolactone formulations contain gamma-caprolactone from about 0.5% bv to about 20% bv and from about 80% bv to about 99.5% bv of N-methyl-2-pyrrolidone. The most preferred gamma-caprolactone formulations include about 5% bv gamma-caprolactone/about 75% bv N-methyl-2-pyrrolidone with the balance water.

Another suitable combination is gamma-butyrolactone and N-methyl-2-pyrrolidone. Preferably, the gamma-butyrolactone is at a concentration of at least about 30% bv, preferably from about 40% bv to about 70% bv. The N-methyl-2-pyrrolidone is at a concentration of from about 20% bv to about 50% bv. The balance may be water, or an optional organic solvent, or mixtures thereof.

The optional organic solvents listed above, when used, may be employed in amounts of from about 0.5% to about 30% bv, preferably from about 5% to about 15% by. Such solvents are employed to assist in de-smearing or removing resin material from a substrate.

The lactone solvent swell compositions of the present invention may optionally include one or more wetting agents. Suitable wetting agents include, but are not limited to, anionic, cationic and nonionic surfactants, and preferably cationic and nonionic surfactants. When such wetting agents are used, they may be present in an amount from about 0.1 to about 10 wt%. Specific amounts of a surfactant may readily be determined by a person of skill in the art with minimal experimentation.

The components of the lactone solvent swell compositions of the present invention may be mixed together by any suitable method or mixing apparatus known in the art. One or more lactones may be mixed with one or more of the amides or optional organic compounds listed above or water. If the desired combination is not miscible, a surfactant may be added in sufficient quantity to disperse the components of the solvent swell.

The compositions of the present invention may be used to swell a variety of resinous materials prior to a subsequent resin-removal step, such as epoxy resins, other thermosetting resins, thermoplastic resins and mixtures thereof. The resins may also include reinforcing materials, such as organic and inorganic fibres or woven fibre cloths. The compositions of the present invention may be employed to swell conventional resin. Preferably, the compositions of the present invention arc employed to swell high Tg resins. By "high Tg resin" it is meant that the glass transition temperature of the resin is about 150° C or greater. Such high Tg resins are particularly suitable for use in sequential build up ("SBU") applications.

Depending upon the particular use and processing conditions chosen, a wide range of resins may be swollen according to the present invention. The present invention is particularly suitable for swelling resinous materials used in printed wiring board manufacture such as FR-4 boards. Suitable resins include, but are not limited to, epoxy resins such as difunctional and multifunctional epoxy resins, polyimide resins, cyanate ester resins, bismaleimide triazine ("BT") resins, resin coated copper ("RCC") type materials, epoxy/polyphenylene oxide resins, and the like, as well as composites thereof. It will be appreciated by those skilled in the art that the compositions of the present invention may also be useful in swelling other resins such as, but not limited to, acrylonitrilebutadienestyrene, polycarbonates ("PC"), polyphenylene oxides ("PPO"), polyphenylene ethers ("PPE"), polyphenylene sulfides ("PPS"), polysulfones ("PS"), polyamides, polyesters such as polyethylcnetercphthalate ("PET") and polybutyleneterephthalate ("PBT"), polyetheretherketones ("PEEK"), liquid crystal polymers, polyurethanes, polyetherimides, and composites thereof.

Typically, the resinous material is disposed on a substrate, such as a printed wiring board or an inner layer for a printed wiring board. In general, the resinous material is contacted with the compositions of the present invention. Such contact may be by any means, such as dipping the resinous material or a substrate containing the resinous material in a vessel containing the present compositions or by spraying the present compositions on the resinous material, or by a combination of dipping and spraying. The present invention may be advantageously used in either vertical or horizontal systems.

The resinous material may be contacted with the present compositions for a period of time up to about 30 minutes. The actual period of time will depend upon the particular resin, the lactone used, any additional components, such as amides or optional organic solvents, in the composition, the temperature of the composition, the amount of resinous material to be textured or removed, and the like. Preferably, the period of time is from about 30 seconds to about 15 minutes, and more preferably from about 1 to about 10 minutes, The solvent swell compositions of the present invention may be used at a wide variety of temperatures. The actual temperature used will depend upon the particular components employed in the solvent swell and the concentrations of such components. Typically, the present compositions may be used at from about 20° to about 95° C, and preferably from about 25° to about 85° C.

Once the resinous material is contacted with the lactone solvent swell compositions of the present invention for a period of time sufficient to swell the resinous material and condition the resinous material for texturing, the resinous material is removed from contact with the composition. The resinous material may then optionally be rinsed, and preferably is rinsed, with water.

The conditioned resinous material may then be textured by etching. Any conventional etching composition may be used. Preferably, the conditioned resinous material is textured by etching with a permanganate composition. Such permanganate etching compositions arc well known to those skilled in the art. In general, such permanganate compositions include one or more sources of permanganate ion, one or more hydroxide ion sources and water. Suitable permanganate ion sources include, but are not limited to, sodium permanganate, potassium permanganate and the like. The concentration of permanganate will generally be in the range of from about 20 to about 150 g/l.

Any alkali metal hydroxide or alkaline earth hydroxide may be used in the permanganate etching compositions as the hydroxide ion source. It is preferred that the hydroxide ion source is an alkali metal hydroxide. Suitable alkali metal hydroxides include lithium hydroxide, sodium hydroxide, potassium hydroxide, rubidium hydroxide, and cesium hydroxide. It is preferred that the hydroxide ion source is sodium hydroxide or potassium hydroxide. Mixtures of hydroxide ion sources may also be used. Typically, the hydroxide ion sources are used in the compositions of the present invention in an amount such that the pH of the permanganate etching composition has a pH of about 12-14.

Once the resinous material is contacted with the permanganate etching composition, it is then typically rinsed with water and then neutralized, such as with dilute acid/hydrogen peroxide.

The compositions of the present invention also arc useful in removing resin, such as resin smear, from resinous substrates. In particular, the present invention is useful to prepare resinous substrates for metallization, for desmearing resin from the inside walls of holes in resinous substrates, for hole cleaning processes for multilayer circuit boards and for etchback processes for circuit boards. It is preferred that the substrate is a printed wiring board. It is further preferred that the printed wiring board includes one or more layers including epoxy resin, glass/epoxy resin, polyimide resins, cyanate ester resins, bismaleimide triazine ("BT") resins, resin coated copper ("RCC") type materials and composites thereof.

Substrates containing resin to be textured and/or removed, such as resin smear, may be processed by any conventional means using the compositions and methods of the present invention. For example, in the manufacture of a printed wiring board ("PWB"), the following steps are typically employed:
1. The PWB is contacted with the solvent swell compositions of the present invention before etching. Such solvent swell conditions the resin for texturing, removes oils or dirt, helps uniformly wet the substrate surfaces, both resin and metal, and permeates and softens the resin slightly which helps the permanganate attack of the resin. In an alternative embodiment, the present solvent swell compositions may be sonicated by any means known in the art.
2. The cleaned PWB is then optionally rinsed to remove the cleaning solution.
3, The rinsed PWB is then contacted with the permanganate etching compositions for a time sufficient to effect the desired resin texturing and/or removal. The actual conditions employed will vary with the type of etching desired, for example, texturing and desmearing may require only a short period of time while etchback may require a longer period of time. Suitable times for texturing and/or desmearing are from about 30 seconds to about 30 minutes, preferably from about 90 seconds to about 10 minutes. In an alternative embodiment, the permanganate etching compositions may be sonicated by any means known in the art.
4. Following permanganate etching, the PWB is thoroughly rinsed.
5. The rinsed PWB is then contacted with an acid neutralization solution, such as dilute sulfuric acid and hydrogen peroxide, to remove substantially all of the permanganate and manganese residues from the board.
6. After acid neutralization, the PWB is again rinsed. The PWB is then ready for subsequent metallization.

Metallization of the PWB may be performed by any suitable method in the art. Suitable methods include, but are not limited to, electroless plating or direct plating of the PWB. Often the PWB contains both a resinous component as well as a metal cladding component. The metal cladding may be copper, nickel or any other suitable metal employed as circuitry. Advantageously, the porous textured surface of the resinous material of the PWB provides an anchoring structure for deposited metal to grasp onto. Such a mechanical means for retaining deposited metal on the resin material improves adhesion between the metal and the resinous material of the PWB. Accordingly, de-lamination of electroplate, especially from resin in through-hole walls, is eliminated or significantly reduced during the life of the electronic devices in which the PWB is employed. Delamination of electroplate from resin in through-hole walls leads to interconnect defects. Also, warping, blistering and cracking of the metallized product is reduced or prevented.

When electroless plating is performed, the porous textured resin material of the PWB is made electrically conductive by employing an activator. Such activators may be colloidal catalysts of noble or non-noble metals. Many commercial activators contain one or more of the noble metals (Au, Ag, Pt, Pd, Ir, Rh, Ru, and Os). Particularly preferred noble metals are Pd, Pt, Ag, and Au. The most preferred is palladium. Often the palladium is employed as a tin-palladium colloid such as the commercially available activator Circuposit 3344® (obtainable from Shipley Company, Marlborough, MA, U.S.A.). Suitable non-noble metals include, but are not limited to, Cu and Ni. The preferred non-noble metal is copper. Often the copper is employed in the colloidal catalyst as a copper oxide.

Advantageously, when the noble and non-noble metal colloidal catalysts are applied to the textured resinous material, the colloidal particles become entrapped within the pores of the surface as well as settling on the top of the textured resinous surface. The colloidal catalyst particles dispersed throughout the porous textured resinous material act as seeds for metal to deposit in the pores and on the surface of the resin. Such a metal layer is continuous across the resin surface and well anchored through the pores of the textured resinous surface to form a metal layer to resin surface bond of high integrity.

The lactone solvent swell composition and method of the present invention may be used to prepare a resinous substrate for any electroless plating method employed in the art. An example of one method of electroless plating is a process according to the following sequence of steps:
1. Contacting a metal clad, epoxy resin PWB that has been textured according to the lactone solvent swell etching and neutraliser method of the present invention.
2. Rinsing the PWB with water for about 4 minutes.
3. Treating the PWB with a sensitizer to optimize catalyst pick-up.
4. Rinsing the PWB with water for about 4 minutes.
5. Etching the metal clad laminate in a microctch for about two minutes.
6. Rinsing the PWB with water for about 4 minutes.
7. Treating the PWB with a pre-dip solution for about 1 minute.
8. Treating the PWB with a tin/palladium catalyst for about 4 minutes.
9. Rinsing the PWB with water for about 4 minutes.
10. Electrolessly depositing metal on the metal cladding and textured resinous material of the PWB.
11. Directly plating metal on the clectrolcssly deposited metal coated PWB.

Suitable activators or colloidal catalysts were discussed above. Accelerators are optional and are employed to increase or optimize the catalytic activity of the activator in plating metal from the bath that provides the source of the metal in electroless plating. Any accelerator employed in the art may be used. An example of a preferred accelerator is the fluoroborate based accelerator. Suitable baths that provide the source of metal in electroless plating are any bath that is employed in the clcctroless plating art. The types and amounts of components in such baths vary extensively. For example, an aqueous bath for electroless copper deposition may contain from about 5.0% to about 25% by weight of copper sulfate, a complexing agent such as EDTA from about 20 to about 40 g/l, a reducing agent such as formaldehyde from about 0.5 to about 8 g/l and sodium hydroxide from about 3 to about 15 g/l.

While the present invention has been described with respect to printed wiring board processes, it is appreciated by those skilled in the art that the present invention may also be applied to a wide variety of resinous substrates that may be used in a wide variety of applications where swelling of the resin is desired.

As mentioned above an advantage of the present invention is that resinous material is textured such that a metal layer may be deposited on the resinous material forming a mechanical bond of high integrity between the metal and resin. The adhesion between the resin and the metal is such that the metal does not readily separate from the resin. Thus, the present invention is particularly suited to applications where porous texturing of a resin is desired.

It has been surprisingly found that the rate of resin removal may be controlled by adjusting the concentration of the lactone in the present compositions, Increasing the lactone concentration increases the amount of resin removed from a substrate for a given period of time. Thus, the present invention provides a method for controlling the rate of resin removal from a substrate using a composition including one or more lactones, including the step of adjusting the concentration of the one or more lactones in the composition. The lactone concentration may be adjusted by a variety of means, such as by adding more or less lactone, amide, organic solvent or water to the composition.

The following example is intended to illustrate further various aspects of the present invention, but is not intended to limit the scope of the invention in any aspect.

### Example

The following comparative tests showed that the lactone solvent swell compositions of the present invention conditioned resinous materials for texturing with an etchant such that a high integrity bond may be formed between the resin and deposited metal. Also, the tests showed that the lactone solvent swells of the present invention reduced resin weight, and are suitable for desmearing procedures during PWB preparation.

Two types of resinous materials were employed to test the lactone solvent swell compositions of the present invention for their ability to swell, condition for texturing and remove resinous material. One resinous material employed was Duraver®-E-Cu quality 117 epoxy base material (obtainable from Isola Laminate Systems Corp., La Crosse, WI, U.S.A.) and the second was Polyclad® 370 epoxy base material (obtainable from Polyclad Laminates, Inc., Franklin, NH, U.S.A). The Duraver®-E-Cu quality 117 epoxy base material (Isola) had a Tg of from about 150° C to about 200° C. Numerical data for the Isola resinous material is tallied in the table below. The base materials were cut into coupons of about 7,5 cm x 7.5 cm and had a thickness of about 1.6 mm. Each coupon had from 10 to 15 through-holes. The diameter of the through-holes was about 1.0 mm. Two sets of Isola coupons were tested and one set of Polyclad® coupons were tested. The Polyclad® coupons and one set of the Isola coupons were copper clad. The bare laminate Isola coupons that were not copper clad were tested for resin loss and desmearing. The weight loss data for the bare laminate Isola coupons are in the table.

Each coupon was dried in a conventional convection oven at about 105° C (about 220° F) for about an hour until a constant weight was achieved. Each coupon was weighed on a standard analytical balance. Each coupon was then treated with a solvent swell composition for about 15 minutes at about 85° C (185° F). Each treated coupon was then rinsed with water for about 4 minutes followed by etching for about 15 minutes at about 85° C to texturize the coupons. The etchant employed was Circuposit® 4130 an alkaline permanganate etching bath (obtainable from Shipley Company, Marlborough, MA). After etching was completed, each coupon was rinsed with water for about 4 minutes followed by treating the coupons with a neutralizer to remove all permanganate residues from the coupons. The neutralizer employed was an aqueous solution of dilute sulfuric acid and hydrogen peroxide. All the coupons were then placed in the conventional convection oven at about 105° C over about 48 hours to dry. After drying, the bare laminate coupons were weighed using the standard analytical balance to determine the weight loss or resin loss from the coupons. The weight of each bare laminate coupon before and after conditioning and etching is recorded in the table below. The weight change is also recorded. The surface area of each Isola bare laminate coupon also was determined and a tally of the weight change/surface area was made. The change in weight/surface area of each coupon provided a more accurate comparison of the loss of resin from the desmear treatment.

The solvent swells used were composed of epsilon-caprolactone, epsilon-caprolactone mixed with N-methyl-2-pyrrolidone (NMP), gamma-caprolactone, gamma-caprolactone mixed with N-methyl-2-pyrrolidone (NMP), gamma-valerolactone, gamma-valcrolactone mixed with N-methyl-2-pyrrolidone (NMP), gamma-butyrolactone (control), gamma-butyrolactone mixed with N-methyl-2-pyrrolidone (NMP), and N-methyl-2-pyrrolidone (NMP) (control). The amounts of the lactones employed ranged from about 1% by to about 50% bv. The balance of the compositions was water to bring each solvent swell composition to about 100% bv. The specific components and amounts of each component used in the solvent swells to treat the coupons are given in the table below.

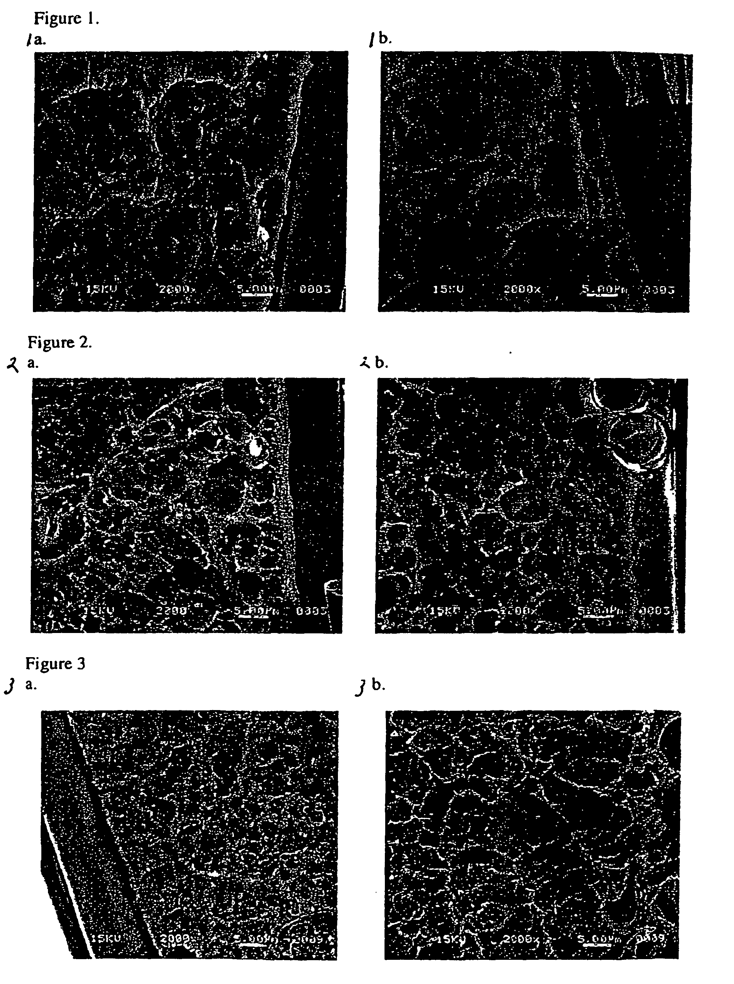

Each coupon had been cut laterally such that the surface of one or more through-holes was examined for texturing. Examination was performed using a standard scanning electron microscope. All of the coupons were observed for texturing and the quality of the texturing was recorded. Poor texturing was given a P, moderate texturing an M, and good texturing a G (see table below). A poor textured resinous material had a smooth and/or shingled or shaled appearance under the electron microscope. Shingled or shaled appearance within the scope of the present invention means splintery or uneven overlapping layers. Moderate texturing showed some porosity in the resinous material with no significant observable shingling or smooth surfaces. Good texturing showed significant porosity. Such porosity covered over about 50% of the solvent swell treated resinous material. Micrographs were taken using a camera attached to the electron microscope. Each micrograph was taken at about 2000X. The micrographs are disclosed in Figures 1A-B to 6A-D of the Figures.

One copper clad Isola and one copper clad Polyclad® coupon were treated with Circuposit® 3302 (control) and Hole Prep® 4125 (control) both glycol ether solvent swell formulations (obtainable from Shipley Company). The numerical values for the coupon treated with Hole Prep® 4125 were not recorded in the table below. Figs. 1A-1B show micrographs of Isola and Polyclad® 370 resinous material that were treated with standard Shipley solvent swell compositions of Circuposit® 3302 and Hole Prep® 4125, respectively. The results were poor. The micrographs showed shingling or shaling and no porosity. Poor results were also obtained with a solvent swell composition containing 40% bv of gamma-butyrolactone/30% bv N-methyl-2-pyrrolidone with the balance water as shown in Figures 3A (Isola) and 3B (Polyclad® 370). The micrographs showed shingling of the resinous material. The uneven overlapping layers or shingling in Figure 3B is especially apparent.

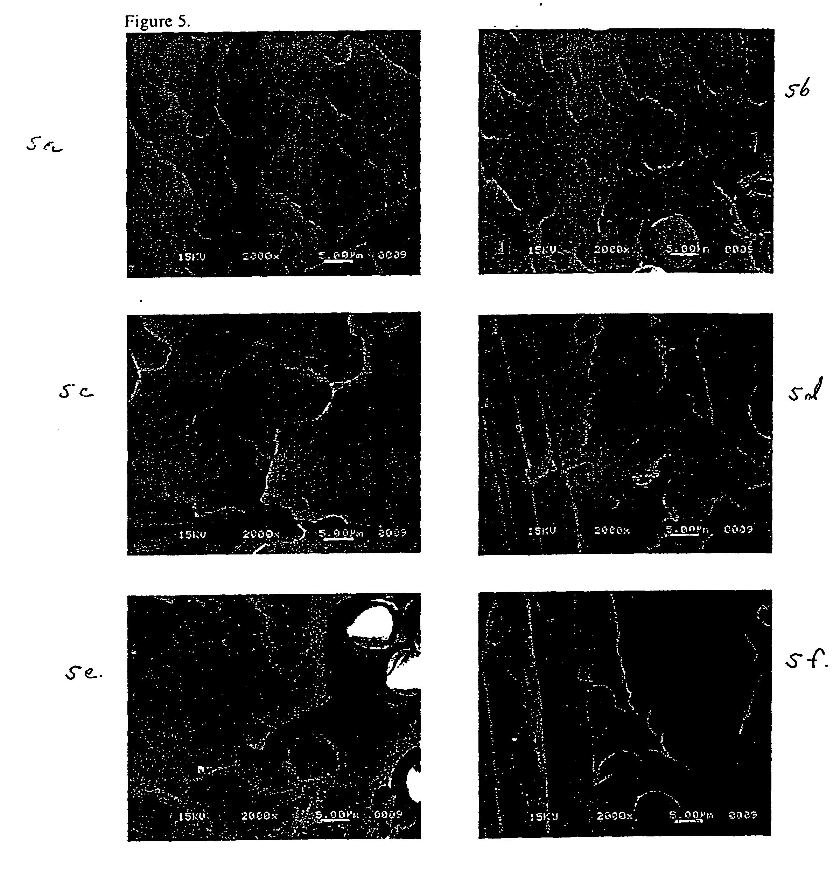

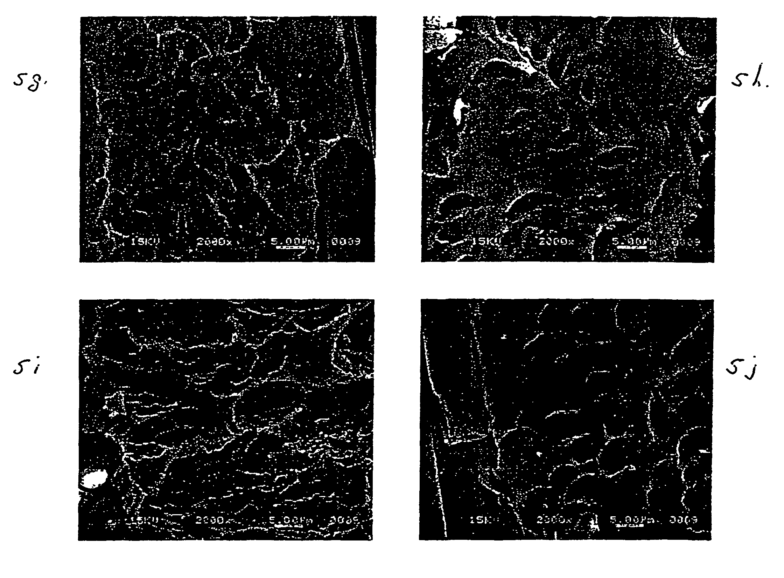

Figures 5A-5J show micrographs of Isola resinous material (5A, C, E, G, and I) and Polyclad® 370 resinous material (5B, D, F, H, and J) that were treated with gamma-butyrolactone. The resinous materials shown in Figures 5A-B, C-D, E-F, G-H, and 1-J were treated with gamma-butyrolactone at concentrations of 10% bv, 20% bv, 30% bv, 40% bv and 50% bv, respectively. The lower the concentration of the gamma-butyrolactone the less texturing occurred. In each micrograph, the texturing was shingling. The most textured surface was the Isola resinous material treated with 50% gamma-butyrolactone as shown in micrograph 51. Although the coupon was well textured, the texturing was shingling. There was no observable porosity.

Figures 2A and 2B show micrographs of Isola (2A) and Polyclad® 370 (2B) treated with a solvent swell containing 40% bv epsilon-caprolactone/30% bv N-methyl-2-pyrrolidone. Good texturing was obtained on both resinous materials. Figures 2A and 2B show extensive porosity.

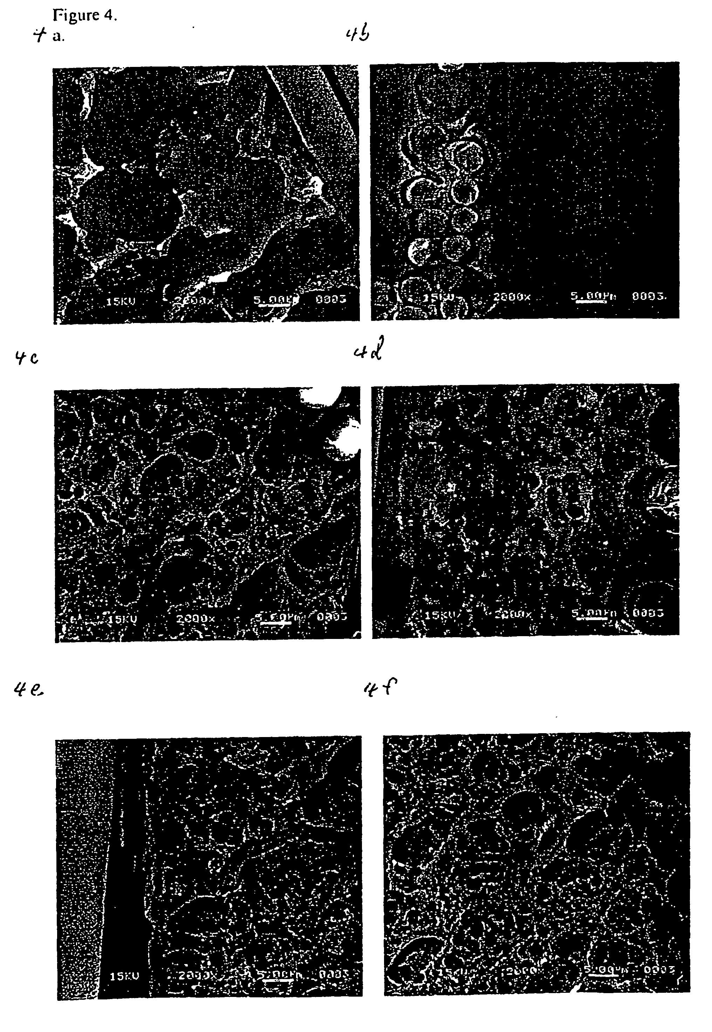

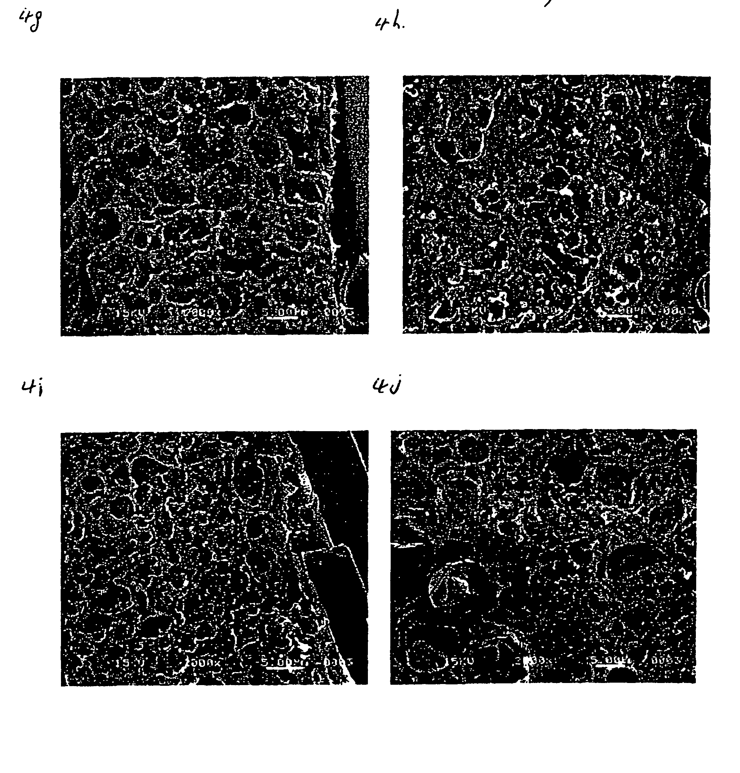

Figures 4A, C, E, G, and I show micrographs of Isola coupons treated with epsilon-caprolactone formulations of 10% bv, 20% bv, 30% bv, 40% by, and 50% bv, respectively. Figures 4B, D, F, H, and J show micrographs of Polyclad® coupons treated with epsilon-caprolactone formulations of 10% bv, 20% bv, 30% bv, 40% bv, and 50% bv, respectively. 10% bv cpsilon-caprolactone formulations had poor results. Figures 4A-4B show some shingling with no porous surface formation. The beginning of a porous surface, or moderate surface, on the resinous material began to form with 20% bv epsilon-caprolatone as seen by the beginning of hole formation in Figures 4C-4D, Good surface texture, or porosity, was obtained with epsilon-caprolactone formulations of 30% bv and higher as shown in Figures 4E-4J.

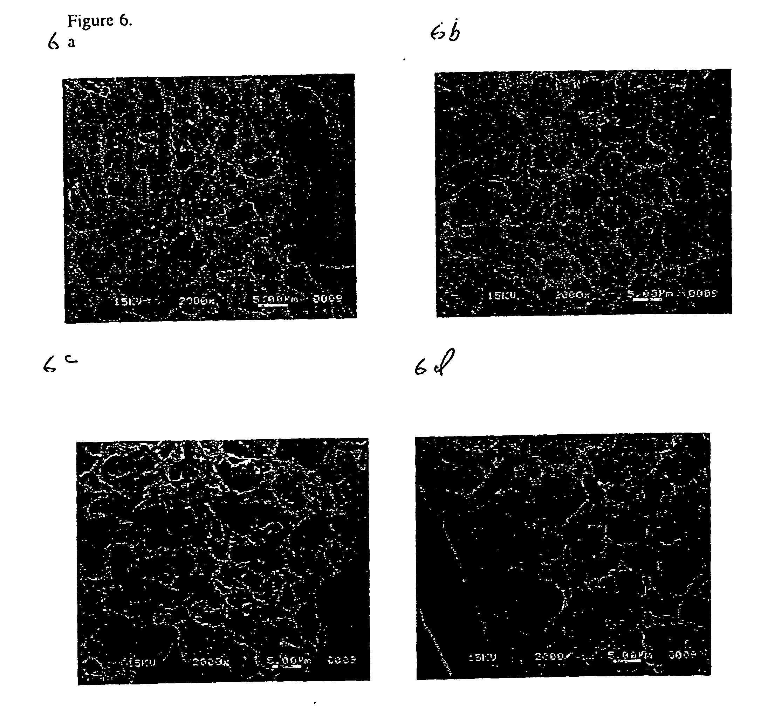

Figures 6A and 6C show micrographs of Isola resinous material treated with 10% bv gamma-caprolactone and 15% bv gamma-caprolactone, respectively. Figures 6B and 6D show micrographs of Polyclad® resinous material treated with 10% bv gamma-caprolactone and 15% bv gamma-caprolactonc, respectively, Good texturing was obtained with the 15% bv gamma-caprolactone as shown by the extensive porosity in Figures 6C and 6D. Moderate texturing was obtained with the 10% bv gamma-caprolactone as shown in Figures 6A and 6B. Porous surfaces are apparent in Figures 6A and 6B, however, the porosity is not as pronounced as in Figures 6C and 6D which show good texturing.

The best texturing or porosity formation shown in the micrographs was obtained from the epsilon-caprolactone and gamma-caprolactone formulations. Such good texturing was especially obtained from the 40% bv epsilon-caprolactonc/30% bv N-methyl-2-pyrrolidone as well as the 30% bv epsilon-caprolactone and higher concentrations, and the 15% bv gamma-caprolactone. The poorest results for the lactone formulations were obtained from the gamma-butyrolactone formulations.

The table below provides additional data for numerous other solvent swell compositions. The best results for texturing resinous material were obtained from the caprolactone formulations, especially when the caprolactone was combined with N-methyl-2-pyrrolidone. Samples 10 through 31 that contained at least 10% bv of cpsilon-caprolactone in combination with N-methyl-2-pyrrolidone produced moderate to good texturing, i.e., significant porosity, on the resinous coupons. Such formulations that provide a moderate or good textured resinous material can form a high integrity bond between the resinous material and a deposited metal.

The poorest texturing was obtained from gamma-butyrolactone formulations with and without N-methyl-2-pyrrolidone as shown by samples 37 through 54 and samples 57 through 59. However, moderate texturing, i.e., some porosity, and good texturing, i.e., significant porosity, was obtained with formulations containing at least 30% bv of gamma-butyrolactone and at least 40% bv N-methyl-2-pyrrolidone (see samples 55 through 56 and samples 60 through 61 and samples 63 through 66). Formulations containing only N-methyl-2-pyrrolidone up to 50 wt.% all had poor texturing of the resinous material (sec samples 2 through 6). Thus, formulations containing at least 30% bv gamma-butyrolactone and at least 40% bv N-methyl-2-pyrrolidone produce suitable textured resinous materials such that a high integrity metal to resin bond can be formed.

In many samples weight loss data for the resinous material from the table shows that there was a correlation between the reduction in weight loss and moderate to good surface texturing of the resin. For example, see samples 12 through 21. As the texturing improves (going from M to G), the weight loss tends to decrease. In samples 26, and 29 through 31, weight gain to the resinous materials occurred along with good texturing. The weight gain was probably due to some solvent retention by the coupons.

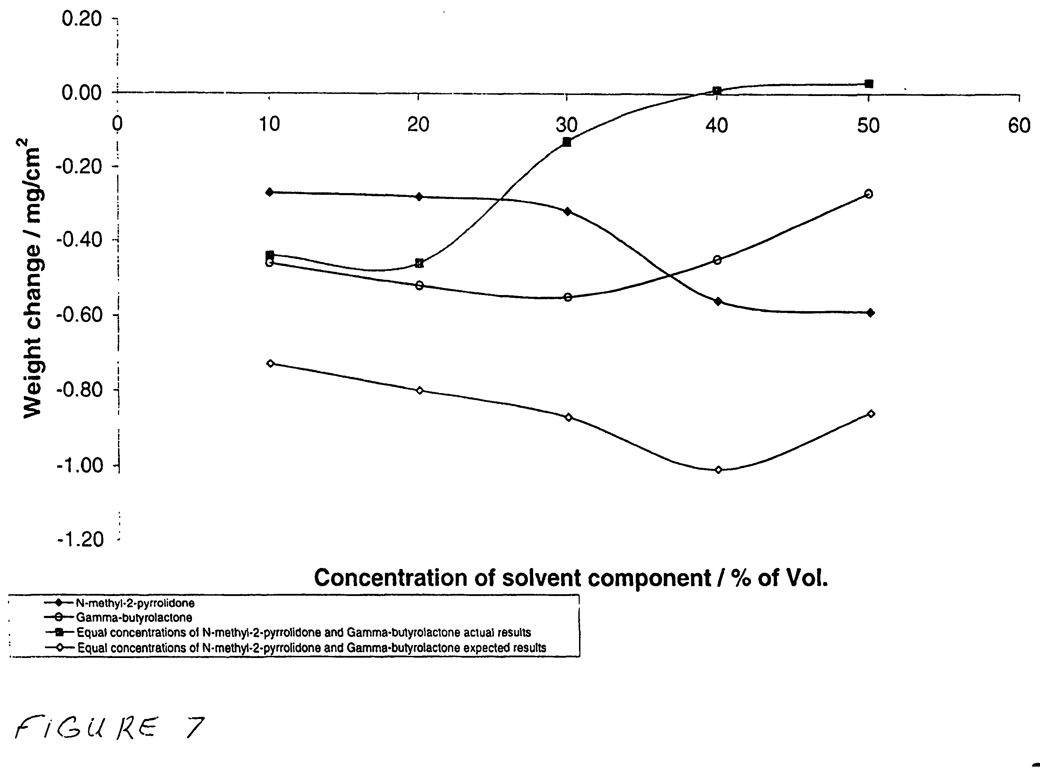

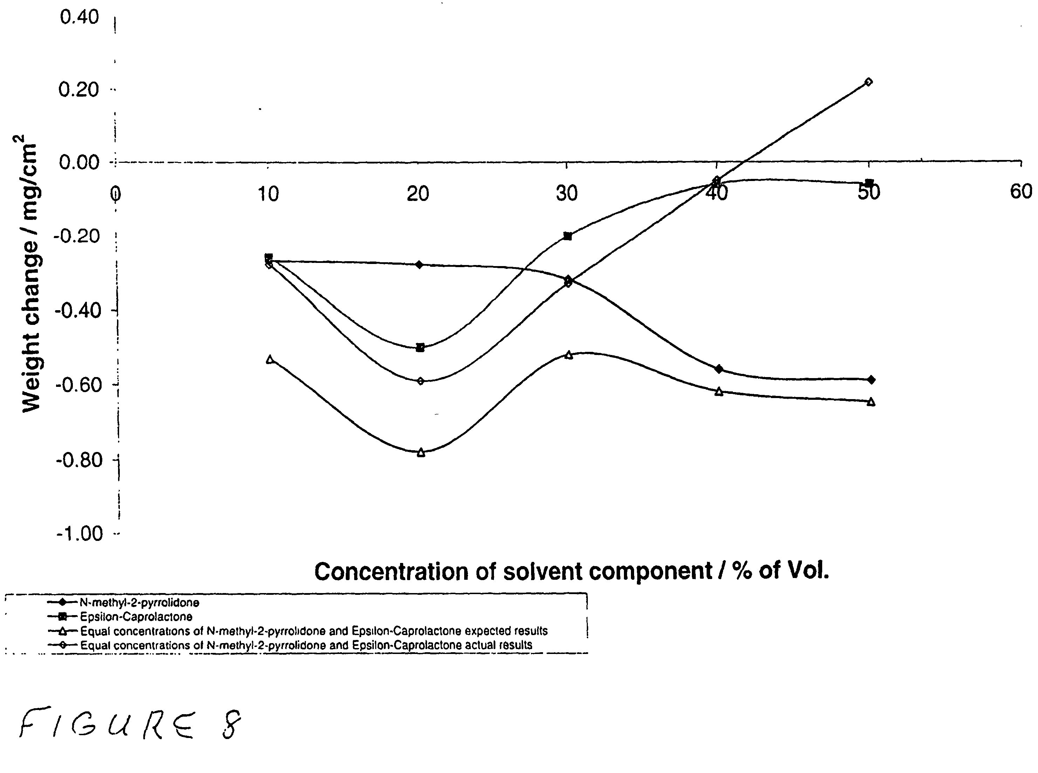

Figures 7 and 8 contrast expected and actual weight loss of resinous material (bare laminate Isola) treated with five different solvent swell compositions. Figure 7 shows a graph of resinous material weight loss vs increasing concentration of solvent swell components. As the concentration of N-methyl-2-pyrrolidone increases in the solvent swell formulation, the weight loss of the resin increases, In the case of gamma-butyrolactone, as the concentration increased the loss of weight of the resin decreased. The expected result from a combination of gamma-butyrolactone and N-methyl-2-pyrrolidone was an increase in weight loss with a slight decrease in weight loss where the concentration of each component was 40% bv and 50% bv. However, the actual results showed a significant decrease in weight loss as the concentration of each component increased from about 20% bv to about 50% bv.

The graph of Figure 8 shows similar results. The weight loss of resinous material increased as the concentration of the N-methyl-2-pyrrolidine increased. In contrast, as the concentration of epsilon-caprolactone increased, the weight loss decreased. The expected weight loss of resinous material treated with the combination of N-methyl-2-pyrrolidone and epsilon-caprolactone was a general increase in weight loss because of the N-methyl-2-pyrrolidone. However, the actual result was a decrease in the weight loss of the resinous material. Part of the decrease in the weight loss was probably due to some solvent retention. The coupon conditioned with the solvent swell composed of epsilon-caprolactone and N-methyl-2-pyrrolidone showed good texturing. Generally, a less negative or more positive weight gain correlates with good surface texturing.

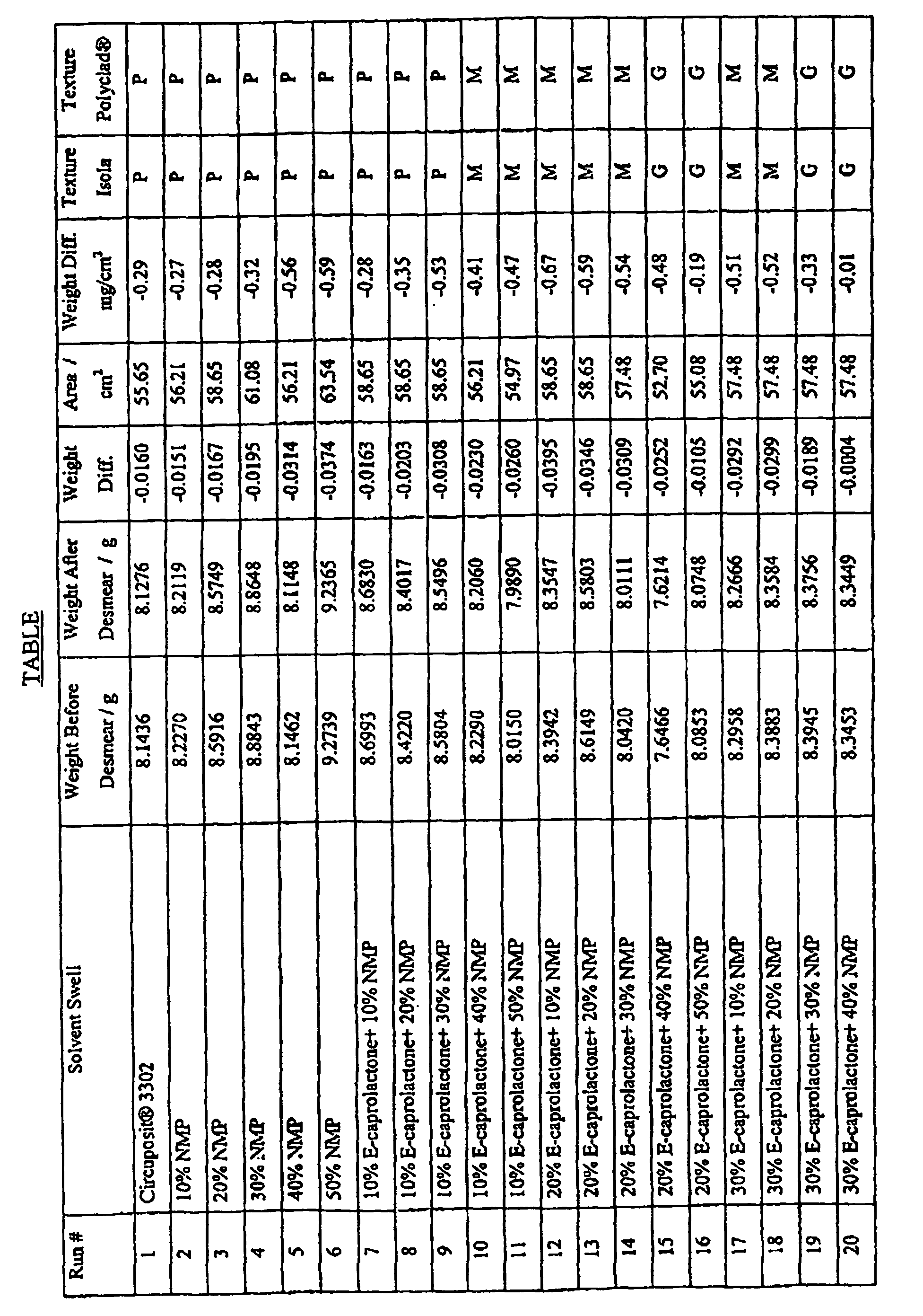

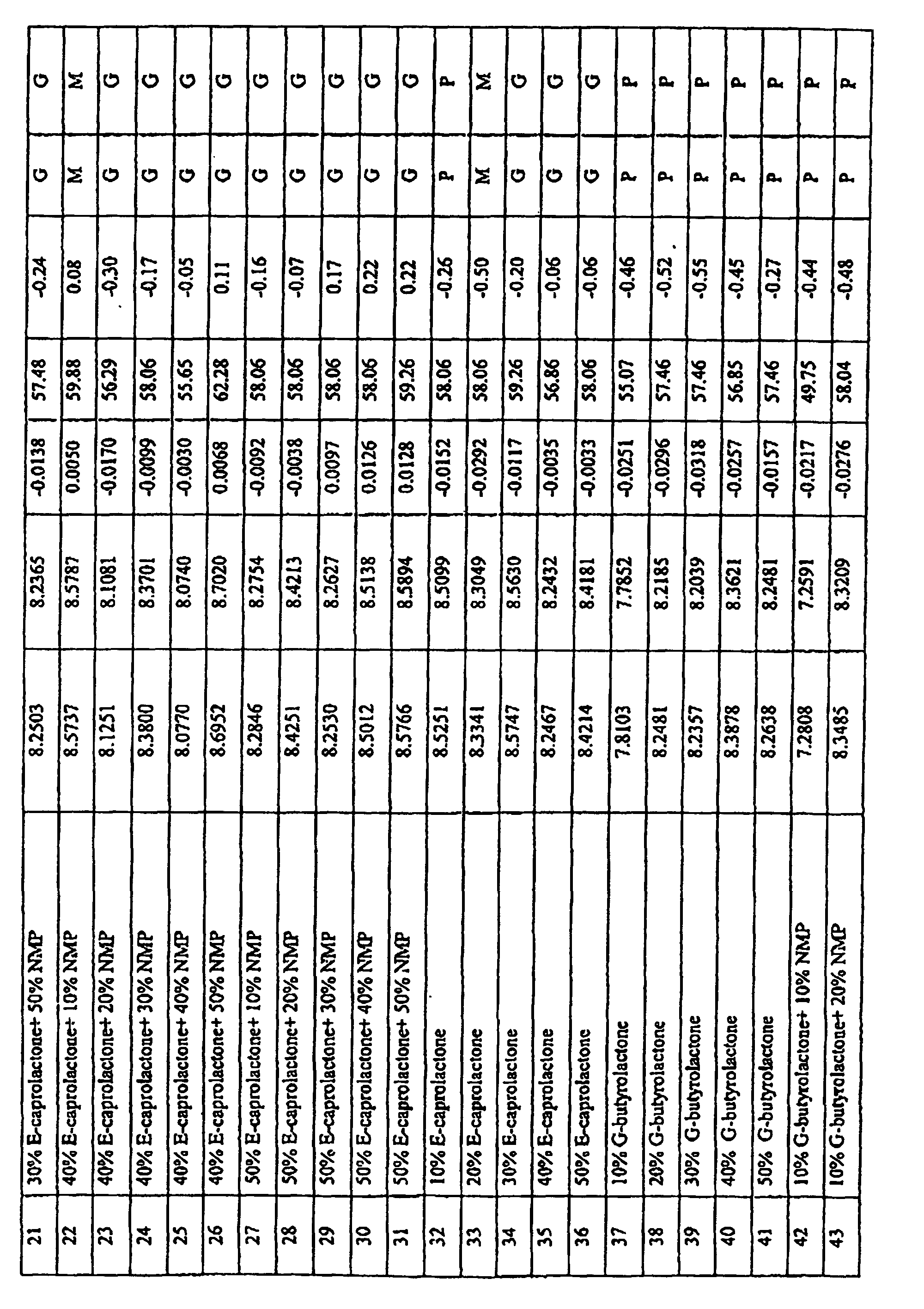

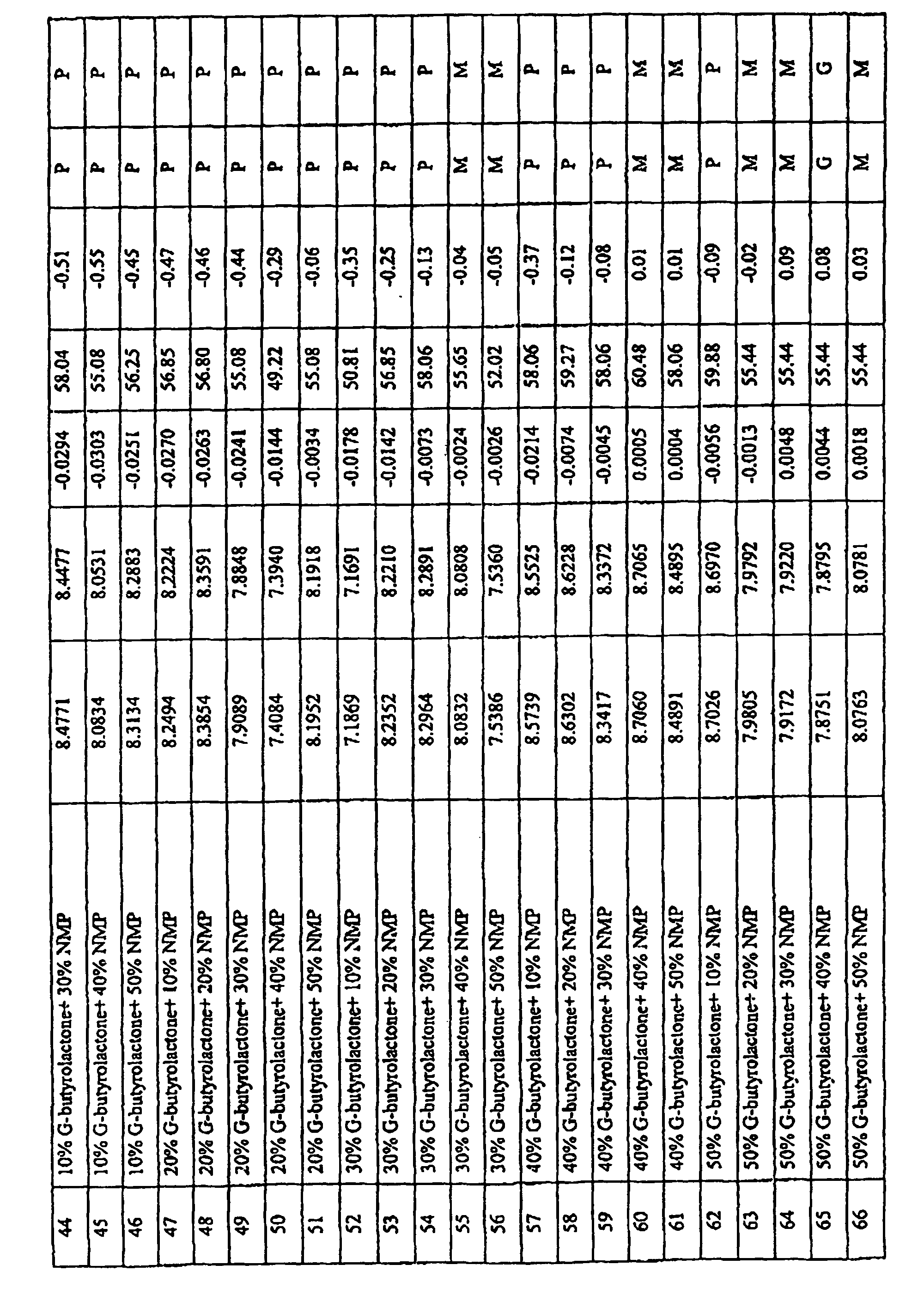

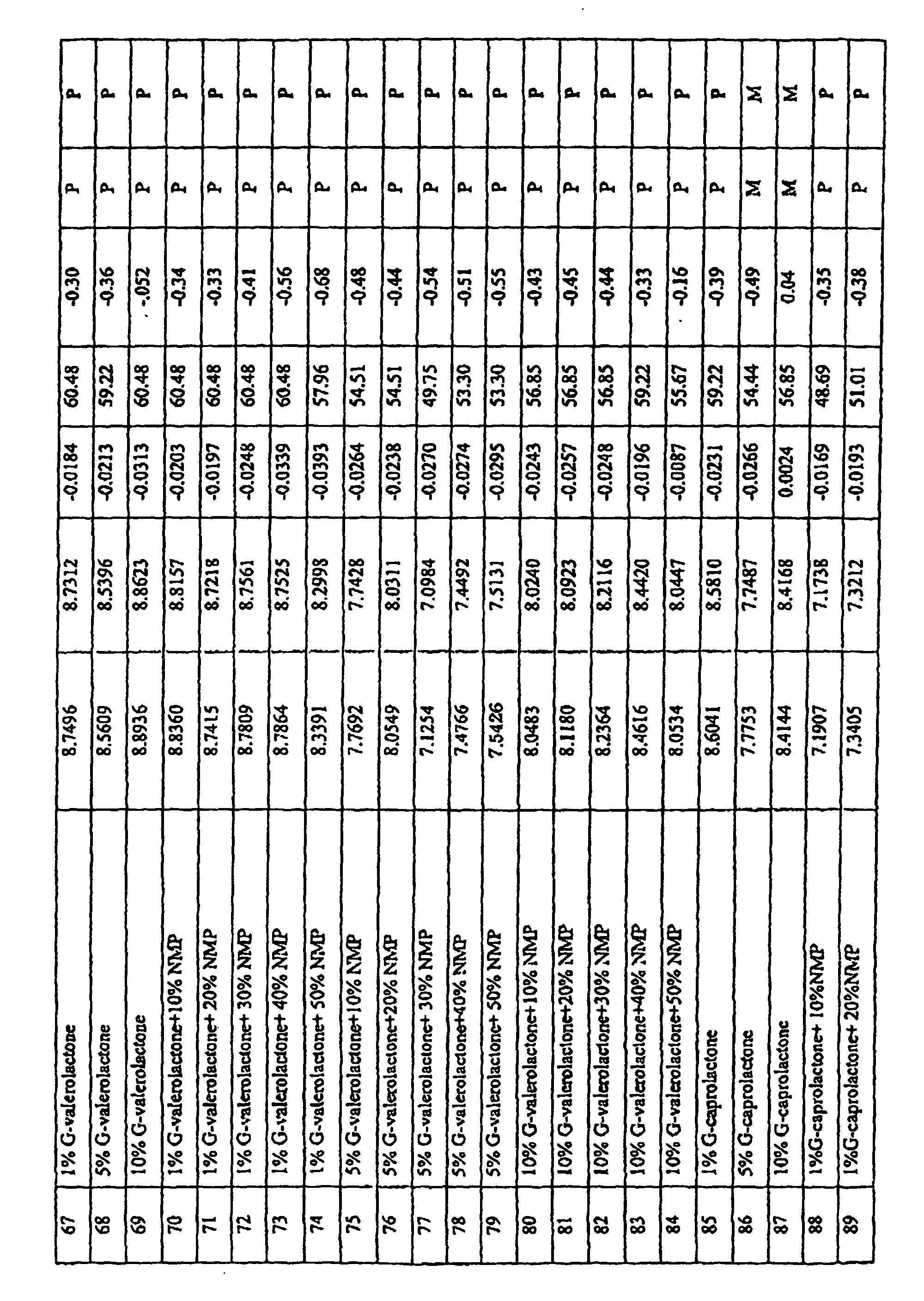

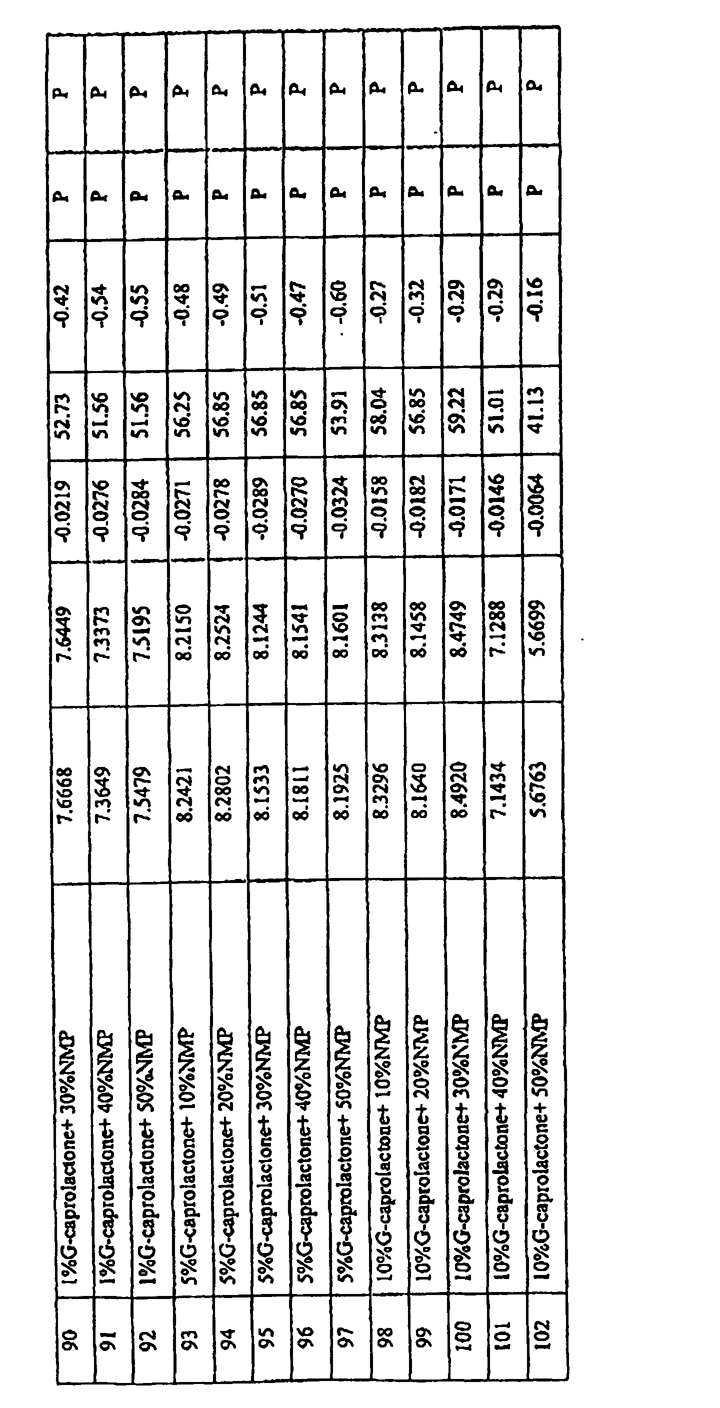

## Claims

1. A solvent swell composition comprising a lactone in a sufficient amount such that the solvent swell composition conditions a resinous material upon contacting the resinous material with the solvent swell composition such that etching the conditioned resinous material provides a porous texturing of the conditioned resinous material, wherein the lactone comprises epsilon-caprolactone, gamma-caprolactone, gamma-valerolactone, or derivatives thereof,

2. The solvent swell composition of claim 1, further comprising an amide.

3. The solvent swell composition of claim 1, further comprising one or more organic solvents of ethylene glycol, diethylene glycol, triethylene glycol, polyethylene glycol, propylene glycol, dipropylene glycol, tripropylene glycol, polypropylene glycol, (C₁-C₄) glycol ethers, (C₁-C₄) glycol ether acetates, (C1-C12) alkyl acetates, ethyl lactate, ethyl butyrate, acetone, hexanone, pentanone, glyoxal, alkylene carbonates or mixtures thereof.

4. The solvent swell composition of claim 1, wherein the resinous material has a Tg of about 150° C or greater.

5. A method of treating a resinous material comprising contacting the resinous material with a solvent swell composition comprising a lactone in a sufficient amount to condition the resinous material for porous texturing with an etchant; and contacting the conditioned resinous material with an etchant to porously texturize the conditioned resinous material, wherein the lactone comprises epsilon-caprolactone, gamma-caprolactone, gamma-valerolactone, or derivatives thereof.

6. The method of claim 5, wherein the Tg of the resinous material is 150°C or higher.

7. The method of claim 5, wherein the resinous material is disposed on a printed wiring board, or an inner layer thereof.

8. The method of claim 5, further comprising the step of contacting the porous texture of the resinous material with an activator such that the activator is dispersed within pores and on a surface of the resinous material.

9. The method of claim 8, further comprising the step of depositing a metal within the pores and on the surface of the porous textured resinous material such that a continuous metal layer is bonded with the resinous material.

## Patentansprüche

1. Lösungsmittelquellzusammensetzung, umfassend ein Lacton in einer ausreichenden Menge, so dass die Lösungmittelquellzusammensetzung ein harzartiges Material beim bzw. nach Inkontaktbringen des harzartigen Materials mit der Lösungmittelquellzusammensetzung derart konditioniert, dass ein Ätzen des konditionierten, harzartigen Materials eine poröse Texturierung des konditionierten, harzartigen Materials bereitstellt, wobei das Lacton Epsilon-Caprolacton, Gamma-Caprolacton, Gamma-Valerolacton oder Derivate davon umfasst.

2. Lösungmittelquellzusammensetzung nach Anspruch 1, welche ferner ein Amid umfasst.

3. Lösungsmittelquellzusammensetzung nach Anspruch 1, welche ferner ein oder mehrere organische Lösungsmittel von Ethylenglycol, Diethylenglycol, Triethylenglycol, Polyethylenglycol, Propylenglycol, Dipropylenglycol, Tripropylenglycol, Polypropylenglycol, (C₁-C₄)-Glycolether, (C₁-C₄)-Glycoletheracetate, (C₁-C₁₂)-Alkylacetate, Ethyllactat, Ethylbutyrat, Aceton, Hexanon, Pentanon, Glyoxal, Alkylencarbonate und Gemische davon umfasst.

4. Lösungsmittelquellzusammensetzung nach Anspruch 1, wobei das harzartige Material eine Tg von etwa 150°C oder höher aufweist.

5. Verfahren zum Behandeln eines harzartigen Materials, umfassend das Inkontaktbringen des harzartigen Materials mit einer Lösungsmittelquellzusammensetzung, umfassend ein Lacton in einer ausreichenden Menge, um das harzartige Material für eine poröse Texturierung mit einem Ätzmittel zu konditionieren, und Inkontaktbringen des konditionierten, harzartigen Materials mit einem Ätzmittel, um das konditionierte, harzartige Material porös zu texturieren, wobei das Lacton Epsilon-Caprolacton, Gamma-Caprolacton, Gamma-Valerolacton oder Derivate davon umfasst.

6. Verfahren nach Anspruch 5, wobei die Tg des harzartigen Materials 150°C oder höher ist.

7. Verfahren nach Anspruch 5, wobei das harzartige Material auf eine gedruckte Verdrahtungsplatte oder einer inneren Schicht davon aufgebracht ist.

8. Verfahren nach Anspruch 5, welches ferner den Schritt des Inkontaktbringens der porösen Textur des harzartigen Materials mit einem Aktivierungsmittel umfasst, so dass das Aktivierungsmittel innerhalb der Poren und auf einer Oberfläche des harzartigen Materials verteilt wird.

9. Verfahren nach Anspruch 8, welches ferner den Schritt des Abscheidens eines Metalls innerhalb der Poren und auf der Oberfläche des porös texturierten, harzartigen Materials umfasst, so dass eine kontinuierliche Metallschicht mit dem harzartigen Material verbunden wird.

## Revendications

1. Composition de solvant gonflant comprenant une lactone en une quantité suffisante de telle façon que la composition de solvant gonflant conditionne un matériau résineux lors de la mise en contact du matériau résineux avec la composition de solvant gonflant, de telle sorte que le décapage du matériau résineux conditionné permette d'obtenir un matériau résineux conditionné à texturation poreuse, dans laquelle la lactone est choisie parmi l'epsilon-caprolactone, la gamma-caprolactone, la gamma-valérolactone, ou des dérivés de ces composés.

2. Composition de solvant gonflant selon la revendication 1, comprenant en outre un amide.

3. Composition de solvant gonflant selon la revendication 1, comprenant en outre un ou plusieurs solvants organiques choisis parmi l'éthylène glycol, le diéthylène glycol, le triéthylène glycol, le polyéthylène glycol, le propylène glycol, le dipropylène glycol, le tripropylène glycol, le polypropylène glycol, des éthers de glycol en C₁-C₄, des acétates d'éther de glycol en C₁-C₄, des acétates d'alkyle en C₁-C₁₂, du lactate d'éthyle, du butyrate d'éthyle, de l'acétone, de l'hexanone, de la pentanone, du glyoxal, des carbonates d'alkylène ou des mélanges de ces composés.

4. Composition de solvant gonflant selon la revendication 1, dans laquelle le matériau résineux a une T_{g} supérieure ou égale à environ 150°C.

5. Procédé permettant de traiter un matériau résineux comprenant la mise en contact du matériau résineux avec une composition de solvant gonflant contenant une lactone en une quantité suffisante pour conditionner le matériau résineux en vue d'obtenir une texturation poreuse à l'aide d'un décapant ; et la mise en contact du matériau résineux conditionné avec un décapant afin de produire un matériau résineux conditionné à texturation poreuse, dans lequel la lactone est choisie parmi l'epsilon-caprolactone, la gamma-caprolactone, la gamma-valérolactone, ou des dérivés de ces composés.

6. Procédé selon la revendication 5, dans lequel la Tg du matériau résineux est supérieure ou égale à 150°C.

7. Procédé selon la revendication 5, dans lequel le matériau résineux est disposé sur une carte de circuit imprimé, ou sur une couche interne de celle-ci.

8. Procédé selon la revendication 5, comprenant en outre l'étape permettant de mettre en contact la texture poreuse du matériau résineux avec un activateur de telle façon que l'activateur soit dispersé à l'intérieur des pores et sur la surface du matériau résineux.

9. Procédé selon la revendication 8, comprenant en outre l'étape permettant de déposer un métal à l'intérieur des pores et sur la surface du matériau résineux à texturation poreuse de telle façon qu'une couche métallique continue soit collée au matériau résineux.
